(19) Europäisches Patentamt

European Patent Office

Office européen des brevets

(11) **EP 0 523 740 B1**

## (12) EUROPEAN PATENT SPECIFICATION

(45) Date of publication and mention
of the grant of the patent:
**04.03.1998 Bulletin 1998/10**

(51) Int Cl.$^6$: **G01R 33/54**

(21) Application number: **92112288.3**

(22) Date of filing: **17.07.1992**

(54) **MRI auto power control method and system**

Verfahren und Vorrichtung zur automatischen Leistungssteuerung bei der Bildgebung mittels
magnetischer Resonanz

Procédé et dispositif de commande automatique d'alimentation pour l'imagerie par résonance
magnétique

(84) Designated Contracting States:
**DE NL**

(30) Priority: **19.07.1991 JP 179850/91**

(43) Date of publication of application:
**20.01.1993 Bulletin 1993/03**

(73) Proprietor: **KABUSHIKI KAISHA TOSHIBA
Kawasaki-shi, Kanagawa-ken 210 (JP)**

(72) Inventor: **Sugiura, Satoshi,
c/o Intellectual Property Div.
Minato-ku, Tokyo (JP)**

(74) Representative: **Blumbach, Kramer & Partner
Patentanwälte
Radeckestrasse 43
81245 München (DE)**

(56) References cited:
**EP-A- 0 242 286         EP-A- 0 391 279
EP-A- 0 391 279         EP-A- 0 414 474
EP-A- 0 439 119         EP-A- 0 463 789
US-A- 4 866 386         US-A- 4 983 921**

## Description

The present invention relates to an MRI auto power control method and system for selecting the optimum power of excitation radio-frequency pulses.

The magnetic resonance is a phenomenon in which atomic nuclei having non-zero spins and magnetic moments and placed in a static magnetic field absorb and radiate electromagnetic energy at specific (resonant) frequencies. The atomic nuclei are resonant at an angular frequency $\omega o$ ($=2\pi \, \nu o$, $\nu$ is the Larmor frequency) given by

$$\omega o = \gamma Ho$$

where $\gamma$ is the gyromagnetic ratio inherent in each type of nucleus and Ho is the strength of the applied static magnetic field.

Apparatus for making in vivo diagnosis utilizing the above nuclear magnetic resonance phenomenon processes electromagnetic signals of the same frequency as above induced after resonance absorption to obtain diagnostic information, on a noninvasive basis, in which magnetic resonance parameters, such as atomic nuclear density, longitudinal relaxation time T1, transverse relaxation time T2, flow, chemical shift, etc., are reflected, for example, in a cross-sectional image of a selected slice of a human body under examination.

In principle, magnetic resonance diagnostic information can be acquired from the whole body of a patient placed in a static magnetic field. However, constraints on the configuration of apparatus and clinical requirements for diagnostic images allow actual apparatus to excite a selected body portion of a patient and acquire diagnostic, information therefrom.

EP-A-0 391 279 discloses a MRI automatic power control method and apparatus capable of obtaining an optimal setting of the RF power for each component of interest in order to improve the signal to noise ratio. The optimal RF power setting is obtained by sequentially changing the setting of the RF power to a plurality of different levels and to determine the signal strength of NMR signals for a target component for each set RF power wherein the signal strength is determined on the basis of spectral data derived from the NMR signals. That RF power setting which results in a maximum signal strength of the NMR signals is used as the optimal RF power setting.

In general, a slice of a body having a certain thickness is selected to be a candidate for imaging. A cross-sectional magnetic resonance (MR) image of the selected slice is produced by performing a data encoding process many times to acquire MR signals, such as echo signals or FID (free induction decay) signals, from the slice and then performing an image reconstruction process based on, for example, two-dimensional Fourier transformation on the MR signals.

Some conventional magnetic resonance imaging (MRI) apparatuses are equipped with an automatic power control (APC) system. The APC is adapted to automatically set the strength of excitation RF pulses at an optimum value. This type of APC has been described and disclosed in Japanese Unexamined Patent Publication No. 61-19 1949 (laid open on Aug. 26, 1986), U. S. Patent No. 4,806,867 and U.S. Patent No. 4,675,608.

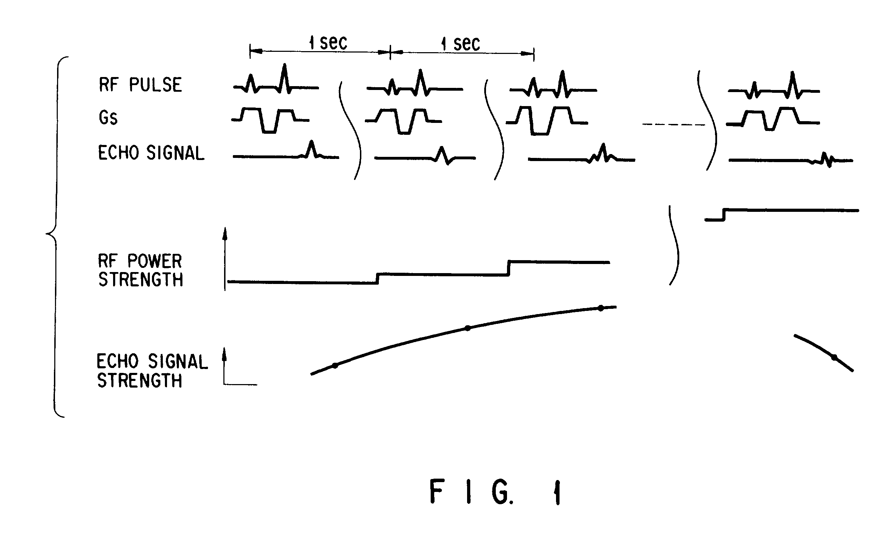

The prior art APC system will be described with reference to Fig. 1. That is, RF pulses (excitation radio-frequency pulses), having their strength varied in steps by varying the attenuation factor of an attenuator, and a slice-selection gradient magnetic field Gs are applied to a slice in a region of interest at preselected pulse repetition intervals, thereby acquiring echo signals from the slice as an MR signal. The RF pulse strength when the maximum MR signal is obtained is identified as the optimum RF pulse strength for that slice. The RF pulse strength determines the flip angles of spins which have a great effect upon image quality. The slice is scanned with RF pulses having the optimum strength. This technique is based on the fact that optimum RF pulse strength varies with regions of a human body and permits optimum MR diagnostic information to be obtained from any region of a human body.

However, a magnetic resonance imaging apparatus equipped with such a conventional APC means has the following problem. That is, in the process of MR signal acquisition with the RF pulse strength varied, in order to, after acquisition of an MR signal by the use of an RF pulse of a certain strength, acquire another MR signal by the use of another RF pulse of a different strength, it is necessary to wait for the longitudinal relaxation of spins once excited. This makes it impossible to shorten the signal acquisition cycle (pulse repetition interval) extremely. The pulse repetition time is generally one second or more. Even if a curve fitting technique is used to decrease the number of measured points, several seconds to tens of seconds will be required to finish all of processes.

It is therefore an object of the present invention to provide an MRI automatic power control method which permits optimum power of excitation radio-frequency pulses to be determined in a short time.

According to a first aspect of the present invention, there is provided an MRI automatic power control method comprising the steps specified in claim 1.

According to a second aspect of the present invention, there is provided an MRI automatic power control system comprising the features specified in claim 4.

This invention can be more fully understood from the following detailed description when taken in conjunction with the accompanying drawings, in which:

Fig. 1 is a schematic illustration of prior art MRI automatic power control;

Fig. 2 is a schematic diagram of a magnetic resonance imaging apparatus into which an MRI automatic power control system according to the present invention is incorporated;

Fig. 3 is a detailed block diagram of the transmitting section of Fig. 2;

Fig. 4 is a diagram illustrating a first embodiment of the MRI automatic power control method and system of the present invention;

Fig. 5 is a flowchart illustrating the MRI automatic power control shown in Fig. 4;

Fig. 6 is a diagram illustrating a second embodiment of the MRI automatic power control method and system according to the present invention; and

Fig. 7 is a flowchart illustrating the MRI automatic power control shown in Fig. 6.

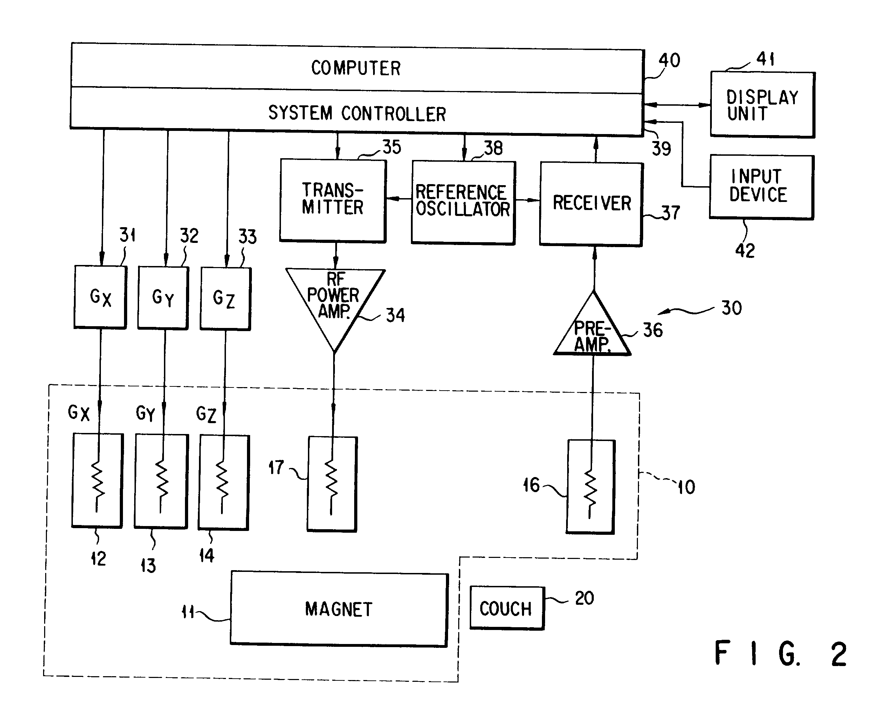

Referring now to Fig. 2, a magnetic resonance imaging apparatus of the present invention comprises a magnet system 10, an examination couch 20 on which a patient is laid, and an electric system 30. The electric system includes an MRI automatic power control system according to the present invention.

The magnet system 10 comprises a magnet 11 for forming a static magnetic field, such as a superconducting magnet, a non-superconducting magnet or a permanent magnet, an X-axis magnetic field gradient forming coil 12 for forming a gradient magnetic field in the X-axis direction, a Y-axis gradient field forming coil 13 for forming a gradient magnetic field in the Y-axis direction, a Z-axis gradient field forming coil 14 for forming a gradient magnetic field in the Z-axis direction, a transmitter coil 17 for applying an excitation radio-frequency pulsed magnetic field (RF pulse), and a receiver coil 16 for receiving a magnetic resonance signal (an echo signal) from a human body under examination. Though not shown, space is formed within the magnet system 10 to accommodate a human body. Further, the static magnetic field, the gradient magnetic fields and the RF pulsed magnetic field can be formed within the space, whereby the composite magnetic field is applied to the human body and echo signals induced in the human body can be acquired.

The human body is laid on the couch 20 and allowed to have access to the space within the magnet system 10.

The electric system 30 comprises an X-axis gradient magnetic field amplifier 31 for the X-axis gradient field coil 12, a Y-axis gradient field amplifier 32 for the Y-axis gradient field coil 13, a Z-axis gradient field amplifier 33 for the Z-axis gradient field coil 14, a transmitter 35 for producing an RF signal to be applied to an RF power amplifier 34, a preamplifier 36 for amplifying an echo signal received by the receiver coil 16, a receiver 37 for detecting the echo signal amplified by the preamplifier 36, a reference signal oscillator 38 for providing a reference signal to the transmitter 35 and the receiver 37, a system controller 39 for controlling the gradient field amplifiers 31, 32 and 33, the transmitter 35, the receiver 37, and the reference signal oscillator 38, a computer 40 for controlling the system controller 39 and producing image information on the basis of data obtained by the receiver 37, a display unit connected to the system controller for visually displaying the image information, and an input unit 42 for inputting imaging diagnosis conditions such as pulse sequence, etc. The components of the electric system 30 construct the MRI automatic power control system according to the present invention.

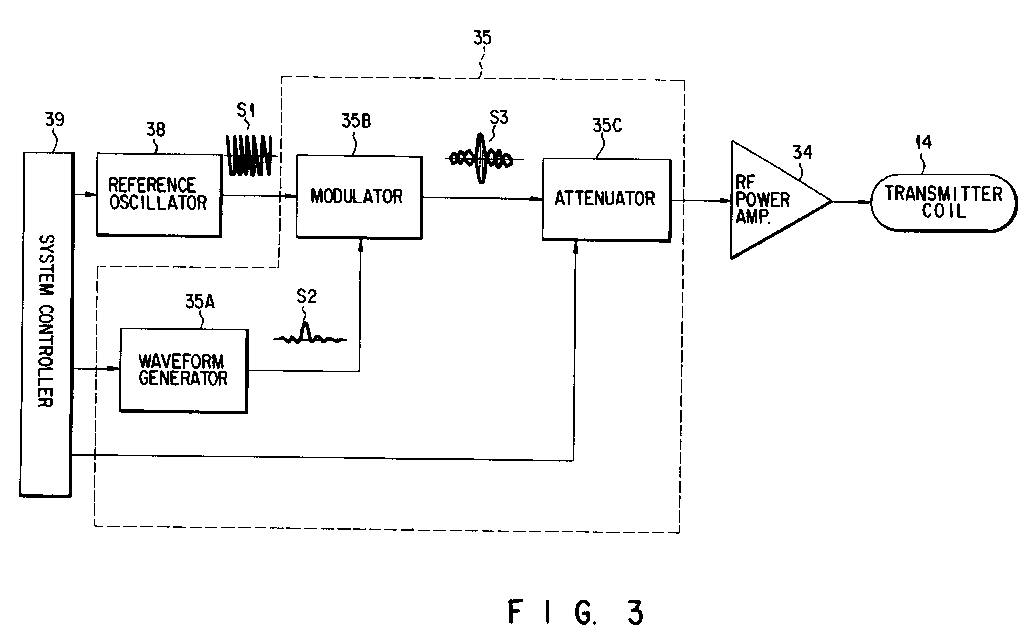

Next, the transmitter 35 will be described in detail with reference to Fig. 3. As shown, the transmitter 35 comprises a waveform generator 35A, a modulator 35B, and an attenuator 35C. The reference signal generator 38 generates a reference signal S1 under the control of the system controller 39. The waveform generator 35A of the transmitter 35 generates a predetermined waveform S2, such as an SINC function waveform, etc., under the control of the system controller 39. The modulator 35B modulates the reference signal S1 with the waveform S2, thereby obtaining a modulated wave. The attenuator 35C attenuates the modulated wave under the control of the system controller 39, feeding the attenuated modulated wave to the RF power amplifier 34. The RF power amplifier 34 amplifies the attenuated modulated wave, feeding the amplified waveform to the transmitter coil 14. As a result, an RF pulsed magnetic field is generated from the transmitter coil 14.

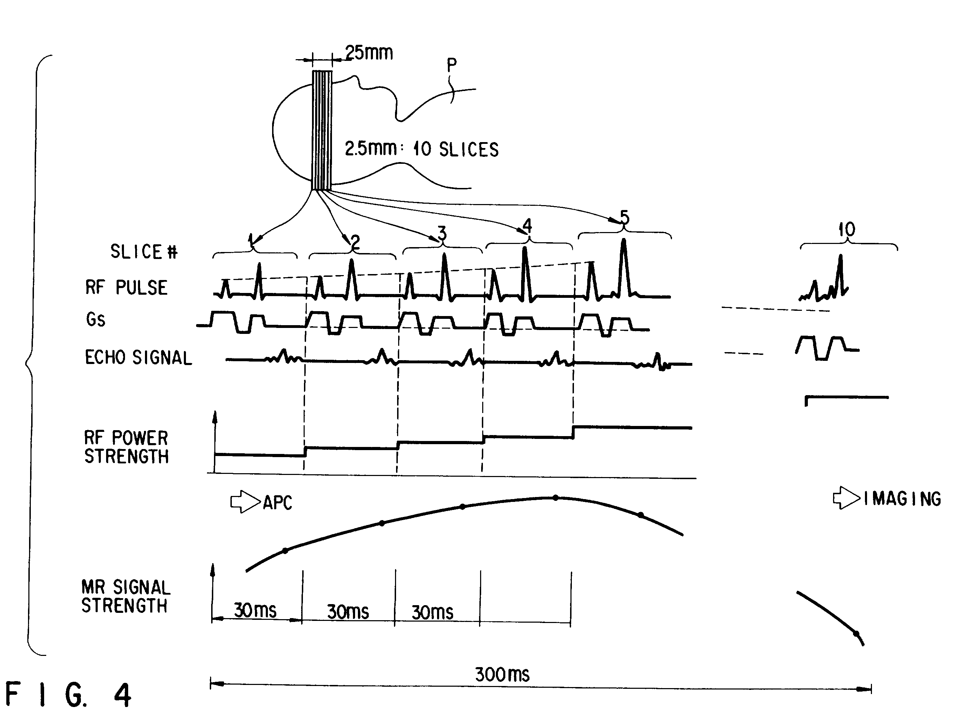

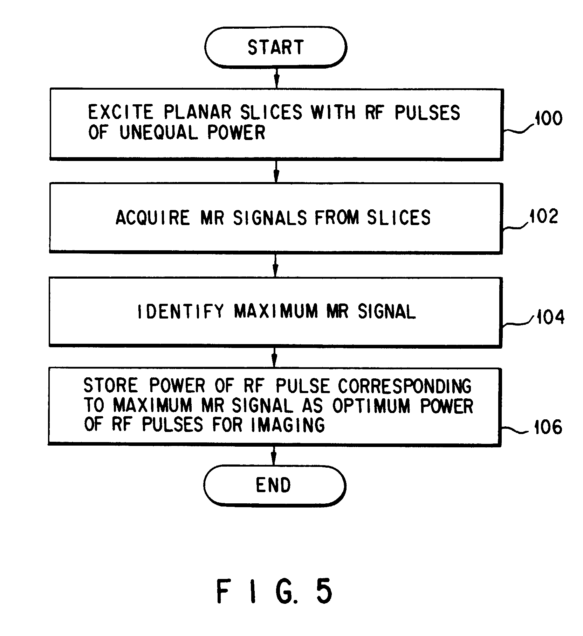

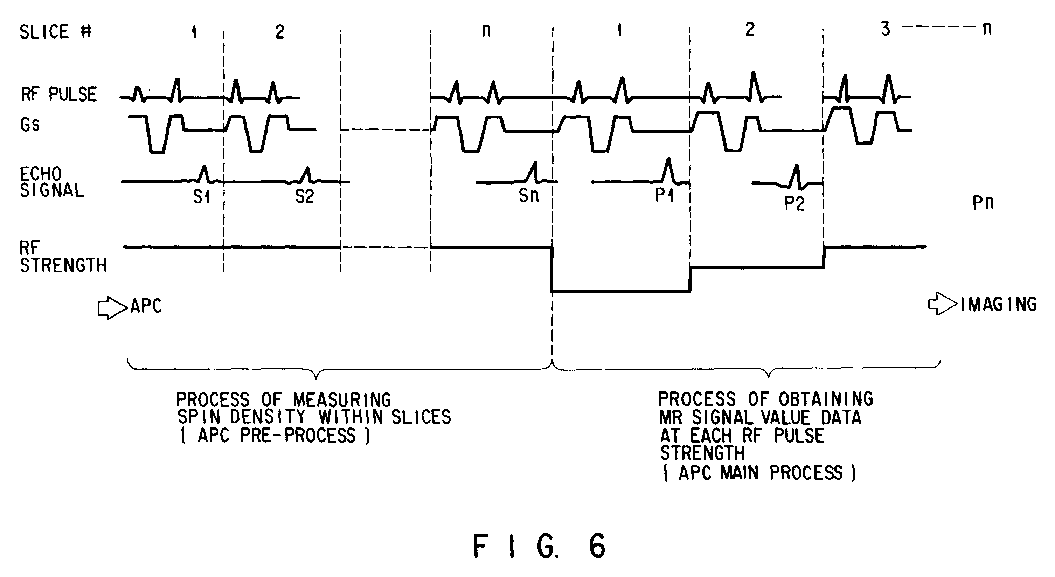

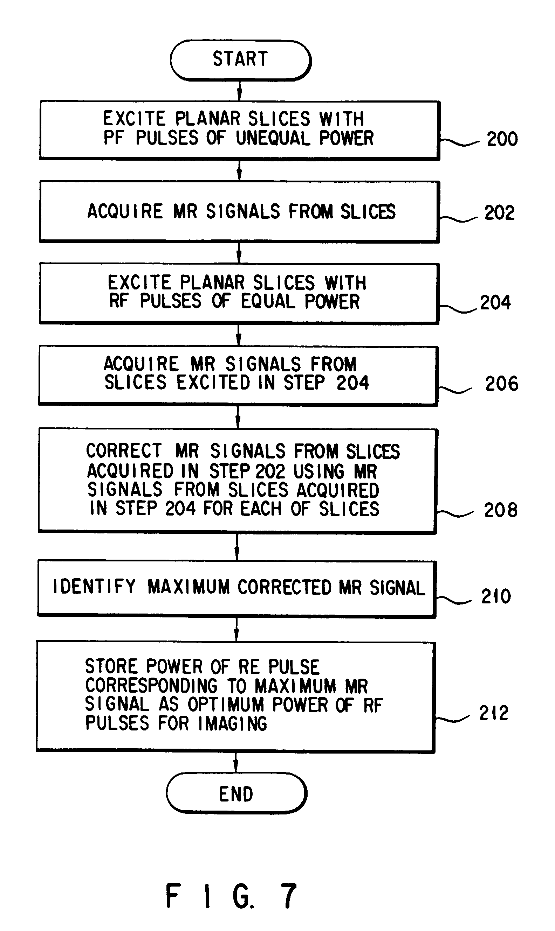

The point of the present embodiment will be described here. The present embodiment is characterized by software used in the system controller 39. This is indicated by a first example shown in Figs. 4 and 5 and by a second example shown in Figs. 6 and 7. Hereinafter, the first example will be described with reference to Figs. 4 and 5, and the second embodiment will be described with reference to Figs. 6 and 7. The first example is directed to APC in which a plurality of neighboring planar slices of a human body are excited in sequence, echo signals are acquired while excitation radio-frequency pulses are applied to the human body with their strength varied, and the strength of an excitation radio-frequency pulse that provides a maximum magnetic resonance signal is identified as the optimum pulse strength for that region. As shown in Fig. 4, in order to selectively excite ten planar slices, each having a thickness of 2.5mm, of a human body P, RF pulses and slice-selection gradient magnetic fields are applied to the human body. In this case, the RF-pulse strength is varied for each slice, for example, in steps. An MR signal (echo signal) is acquired for each slice (at each RF pulse) in steps 100 and 102. An MR signal at maximum is identified in step 104. The strength of an RF pulse that provides the maximum MR signal is stored as the optimum RF pulse strength for the excitation region in this example in a memory of the system controller 39 or the computer 40 (step 106). In imaging the excitation region in this example, RF pulses are applied to the human body with their strength set to the optimum strength.

Assuming the time required to acquire data from each slice to be 30 msec, the APC in this example will be completed in 300 msec. In order to avoid interference in magnetic resonance phenomenon between neighboring slices, and, preferably, in order not to excite neighboring slices continuously, it will be needed to use a technique.

The above-described first example is based on the assumptions that, since MR signals from different slices are compared, the neighboring slices are substantially equal in property (structure) to one another, and there is little difference in quantity of protons among the slices.

Next, reference will be made to Figs. 6 and 7 to describe a technique of obtaining APC data that is suitable for the case where the above assumptions do not hold, for example, where a region to which APC is applied is large (multiple slices of great thickness). The second example is comprised of an APC pre-process and an APC main process. The APC main process is performed after the APC pre-process has been performed. Data Pj obtained by the APC main process is corrected using data Sj obtained by the APC pre-process for each planar slice, thereby obtaining corrected APC data Aj (steps 200 and 203). Note that $1 \leq J \leq n$, n being the number of measured points.

The APC pre-process will be described in detail. MR signals are acquired from the same planar slices as those in the APC main process with the strength of RF pulses kept constant (steps 204 and 206). Consider the strength of each MR signal as a quantity that reflects the spin density in a corresponding planar slice. The above APC data from each slice is divided by a corresponding quantity. That is, let an MR signal value obtained from each planar slice with the strength of RF pulses kept constant be Sj (S1 - Sn), and let an MR signal value from each planar slice with the strength of RF pulses varied in steps be Pj (P1 - Pn). Then corrected APC data is obtained as $Aj = Pj/Sj$ (step 208). The maximum corrected APC data Aj is identified (step 210). The strength of an RF pulse that provides an MR signal corresponding to the maximum corrected APC data is stored as the optimum RF pulse strength in a memory in the system controller 39 or the computer 40 (step 212). Using RF pulses having the optimum strength, imaging of the excitation region is performed.

Although the preferred embodiments of the present invention have been disclosed and described, it is apparent that other embodiments and modifications are possible. For example, in order to improve accuracy, the optimum set value will be obtained by curve-fitting of a curve drawn by a plurality of MR signals acquired with some function. This will also decrease the number of measured points. Moreover, accuracy will be improved by changing the strength of RF pulses coarsely at first and then finely in the neighborhood of the optimum value. Furthermore, in the case where the number of measured points is decreased by the use of a curve fitting technique, the process of compensating for difference in spin density between planar slices can be omitted by decreasing the thickness of each slice and acquiring MR signals from closer slices for subsequent utilization. Alternatively, increasing the thickness of each slice will improve the signal-to-noise ratio and the accuracy of APC data.

## Claims

1. A MRI automatic power control method of selecting optimum power of excitation radio-frequency pulses for use in a MRI apparatus which applies gradient magnetic fields and excitation radio-frequency pulses to a subject under examination placed in a static magnetic field to thereby induce magnetic resonance within a selected region of said subject and detects magnetic resonance signals from said selected region of said subject to obtain imaging information of said subject, characterized by comprising:

   a first step (100, 200) of exciting each of a plurality of regions of a subject under examination with an excitation radio-frequency pulse of a different power;
   a second step (102, 202) of acquiring a magnetic resonance signal from each of said plurality of regions excited by said first step;
   a third step (104, 210) of identifying a maximum magnetic resonance signal contained in said magnetic resonance signals acquired by said second step from said plurality of regions of said subject; and
   a fourth step (106, 212) of storing the power of the excitation radio-frequency pulse that has provided said maximum magnetic resonance signal identified by said third step as the optimum power of said excitation radio-frequency pulses.

2. The MRI automatic power control method according to claim 1, characterized in that said first step (100) excites a plurality of regions that are adjacent to one another in space with excitation radio-frequency pulses of different powers.

3. The MRI automatic power control method according to claim 1, characterized by further comprising:

   a fifth step (204) of exciting said plurality of regions of said subject with excitation radio-frequency pulses of an equal power;
   a sixth step (206) of acquiring magnetic resonance signals from said plurality of regions of said subject excited by said fifth step; and
   a seventh step (208) of correcting said magnetic resonance signals acquired by said second step using said magnetic resonance signals acquired by said sixth step for each of said plurality of regions.

4. A MRI automatic power control system for selecting optimum power of excitation radio-frequency pulses for use in a MRI apparatus which applies gradient magnetic fields and excitation radio-frequency pulses to a subject under examination placed in a static magnetic field to thereby induce magnetic resonance within a selected region of said subject and detects magnetic resonance signals from said selected region of said subject to obtain imaging information of said subject, characterized by comprising:

first means (11, 12, 13, 14, 15, 31, 32, 33, 34, 35, 39) for exciting each of a plurality of regions of a subject under examination with an excitation radio-frequency pulse of a different power;
second means (16, 36, 37, 39) for acquiring a magnetic resonance signal from each of said plurality of regions excited by said first means (11, 12, 13, 14, 15, 31, 32, 33, 34, 35, 39);
third means (40) for identifying a maximum magnetic resonance signal contained in said magnetic resonance signals acquired by said second means (16, 36, 37, 39) from said plurality of regions of said subject; and
fourth means (40) for storing the power of the excitation radio-frequency pulse that has provided said maximum magnetic resonance signal identified by said third means (40) as the optimum power of said excitation radio-frequency pulses.

5. The MRI automatic power control system according to claim 4, characterized in that said first means (11, 12, 13, 14, 15, 31, 32, 33, 34, 35, 39) excites a plurality of regions that are adjacent to one another in space with excitation radio-frequency pulses of different powers.

6. A MRI automatic power control system according to claim 4, characterized by further comprising

fifth means (11, 12, 13, 14, 15, 31, 32, 33, 34, 35, 39) for exciting said plurality of regions of said subject with excitation radio-frequency pulses of an equal power;
sixth means (16, 36, 37, 39) for acquiring magnetic resonance signals from said plurality of regions of said subject excited by said fifth means (11, 12, 13, 14, 15, 31, 32, 33, 34, 35, 39); and
seventh means (40) for correcting said magnetic resonance signals acquired by said second means (16, 36, 37, 39) using said magnetic resonance signals acquired by said sixth means (16, 36, 37, 39) for each of said plurality of regions.

**Patentansprüche**

1. Verfahren zur automatischen Leistungssteuerung bei der Bildgebung mittels magnetischer Resonanz, bei dem eine optimale Leistung für hochfrequente Erregungsimpulse ausgewählt wird und das für den Einsatz in einem mit magnetischer Resonanz arbeitenden Bildgabegerät ausgelegt ist, bei dem Gradientenmagnetfelder und hochfrequente Erregungsimpulse an ein in Untersuchung befindliches Subjekt, das in einem statischen Magnetfeld angeordnet ist, angelegt werden, um hierdurch eine magnetische Resonanz innerhalb einer ausgewählten Region des Subjekts zu induzieren, und Magnetresonanzsignale von der ausgewählten Region des Subjekts erfaßt werden, um hierdurch eine Bildgabeinformation bezüglich des Subjekts zu erhalten, **gekennzeichnet** durch

einen ersten Schritt (100, 200), bei dem jede aus einer Vielzahl von Regionen eines in Untersuchung befindlichen Subjekts mittels eines hochfrequenten Erregungsimpulses mit einer unterschiedlichen Leistung erregt wird;
einen zweiten Schritt (102, 202), bei dem ein magnetisches Resonanzsignal von jeder aus der Vielzahl von bei dem ersten Schritt erregten Regionen erhalten wird;
einen dritten Schritt (104, 210), bei dem ein maximales Magnetresonanzsignal, das in den Magnetresonanzsignalen enthalten ist, die bei dem zweiten Schritt von der Mehrzahl von Regionen des Subjekts erhalten wurden, identifiziert wird; und
einen vierten Schritt (106, 212), bei dem die Leistung desjenigen hochfrequenten Erregungsimpulses, der das maximale, bei dem dritten Schritt identifizierte Magnetresonanzsignal hervorgerufen hat, als die optimale Leistung der hochfrequenten Erregungsimpulse gespeichert wird.

2. Verfahren zur automatischen Leistungssteuerung bei der Bildgebung mittels magnetischer Resonanz, gemäß dem Patentanspruch 1, dadurch **gekennzeichnet**, daß bei dem ersten Schritt (100) eine Mehrzahl von Regionen, die einander räumlich benachbart sind, mit hochfrequenten Erregungsimpulsen mit unterschiedlichen Leistungen erregt werden.

3. Verfahren zur automatischen Leistungssteuerung bei der Bildgebung mittels magnetischer Resonanz, gemäß dem Patentanspruch 1, **gekenn-**

**zeichnet** durch:

eine fünften Schritt (204), bei dem die Mehrzahl von Regionen des Subjekts mit hochfrequenten Erregungsimpulsen mit gleicher Leistung erregt werden;
einen sechsten Schritt (206), bei dem Magnetresonanzsignale von der Mehrzahl von bei dem fünften Schritt erregten Regionen des Subjekts ermittelt werden; und
einen siebten Schritt (208), bei dem die Magnetresonanzsignale, die bei dem zweiten Schritt gewonnen wurden, unter Heranziehung der Magnetresonanzsignale, die bei dem sechsten Schritt für jede der Vielzahl von Regionen gewonnen wurden, korrigiert werden.

4. Steuersystem zur automatischen Leistungssteuerung bei der Bildgebung mittels magnetischer Resonanz, das zum Auswählen der optimalen Leistung von hochfrequenten Erregungsimpulsen für den Einsatz bei einem mit Magnetresonanz arbeitenden Bildgabegerät ausgelegt ist, bei dem Gradientenmagnetfelder und hochfrequente Erregungsimpulse an ein in der Untersuchung befindliches und in einem statischen Magnetfeld angeordnetes Subjekt angelegt werden, um hierdurch eine Magnetresonanz in einer ausgewählten Region des Subjekts zu induzieren, und Magnetresonanzsignale von der ausgewählten Region des Subjekts erfaßt werden, um hierdurch eine Bildgabeinformation bezüglich des Subjekts zu gewinnen, **gekennzeichnet** durch:

eine erste Einrichtung (11, 12, 13, 14, 15, 31, 32, 33, 34, 35, 39) zum Erregen jeder aus einer Mehrzahl von Regionen eines in Untersuchung befindlichen Subjekts mit einem hochfrequenten Erregungsimpuls mit einer unterschiedlichen Leistung;
eine zweite Einrichtung (16, 36, 37, 39) zum Gewinnen eines Magnetresonanzsignals von jeder der Mehrzahl von durch die erste Einrichtung (11, 12, 13, 14, 15, 31, 32, 33, 34, 35, 39) erregten Regionen;
eine dritte Einrichtung (40) zum Identifizieren eines maximalen Magnetresonanzsignals, das in den Magnetresonanzsignalen enthalten ist, die durch die zweite Einrichtung (16, 36, 37, 39) von der Mehrzahl von Regionen des Subjekts gewonnen wurden; und
eine vierte Einrichtung (40) zum Speichern der Leistung desjenigen hochfrequenten Erregungsimpulses, der zu dem maximalen, durch die dritte Einrichtung (40) identifizierten Magnetresonanzsignal führte, als die optimale Leistung der hochfrequenten Erregungsimpulse.

5. Steuersystem zur automatischen Leistungssteuerung bei einer Bildgebung mittels magnetischer Resonanz, gemäß dem Patentanspruch 4, dadurch **gekennzeichnet**, daß die erste Einrichtung (11, 12, 13, 14, 15, 31, 32, 33, 34, 35, 39) eine Mehrzahl von Regionen, die einander räumlich benachbart sind, mit hochfrequenten Erregungsimpulsen mit unterschiedlichen Leistungen erregt.

6. Steuersystem zur automatischen Leistungssteuerung bei einer Bildgebung mittels magnetischer Resonanz, gemäß dem Patentanspruch 4, **gekennzeichnet** durch:

eine fünfte Einrichtung (11, 12, 13, 14, 15, 31, 32, 33, 34, 35, 39) zum Erregen der Mehrzahl von Regionen des Subjekts mit hochfrequenten Erregungsimpulsen mit gleicher Leistung;
eine sechste Einrichtung (16, 36, 37, 39) zum Gewinnen von Magnetresonanzsignalen von der Mehrzahl von Regionen des Subjekts, die durch die fünfte Einrichtung (11, 12, 13, 14, 15, 31, 32, 33, 34, 35, 39) erregt wurden; und
eine siebte Einrichtung (70) zum Korrigieren der Magnetresonanzsignale, die durch die zweite Einrichtung (16, 36, 37, 39) gewonnen wurden, unter Verwendung der Magnetresonanzsignale, die durch die sechste Einrichtung (16, 36, 37, 39) für jede der Mehrzahl von Regionen gewonnen wurden.

**Revendications**

1. Procédé de commande de puissance automatique pour système d'imagerie à résonance magnétique, consistant à choisir une puissance optimum pour l'excitation d'impulsions à radio-fréquences pour l'utilisation dans un appareil d'imagerie à résonance magnétique qui applique des champs magnétiques en gradient et des impulsions d'excitation à radio-fréquences vers un objet en cours d'examen placé dans un champ magnétique statique pour induire ainsi une résonance magnétique dans une région choisie dudit objet, et qui détecte des signaux de résonance magnétique depuis ladite région choisie dudit objet afin d'obtenir des informations d'imagerie dudit objet, caractérisé en ce qu'il comprend :

- une première étape (100, 200) consistant à exciter chacune des régions d'une pluralité de régions d'un objet en cours d'examen avec une impulsion d'excitation à radio-fréquences d'une puissance différente ;
- une seconde étape (102, 202) consistant à acquérir un signal de résonance magnétique depuis chacune desdites régions de la pluralité de régions excitées par ladite première étape ;

- une troisième étape (104, 210) consistant à identifier un signal de résonance magnétique maximum contenu dans lesdits signaux de résonance magnétique acquis par ladite seconde étape depuis ladite pluralité de régions dudit objet ; et

- une quatrième étape (106, 212) consistant à stocker la puissance de l'impulsion d'excitation à radio-fréquences qui a fourni ledit signal de résonance magnétique maximum identifié par ladite troisième étape comme étant la puissance optimum desdites impulsions d'excitation à radio-fréquences.

2. Procédé de commande de puissance automatique pour système d'imagerie à résonance magnétique selon la revendication 1, caractérisé en ce que ladite première étape (100) excite une pluralité de régions qui sont adjacentes les unes des autres dans l'espace avec excitation d'impulsions à radio-fréquences de puissances différentes.

3. Procédé de commande de puissance automatique pour système d'imagerie à résonance magnétique selon la revendication 1, caractérisé en ce qu'il comprend en outre :

- une cinquième étape (204) consistant à exciter ladite pluralité de régions dudit objet avec excitation d'impulsions à radio-fréquences d'une puissance égale ;

- une sixième étape (206) consistant à acquérir des signaux de résonance magnétique depuis ladite pluralité de régions dudit objet excitées par ladite cinquième étape ; et

- une septième étape (208) consistant à corriger lesdits signaux de résonance magnétique acquis par ladite seconde étape en utilisant lesdits signaux de résonance magnétique acquis par ladite sixième étape pour chacune des régions de ladite pluralité de régions.

4. Système de commande de puissance automatique pour un système d'imagerie à résonance magnétique, pour choisir une puissance optimum d'excitation d'impulsions à radio-fréquences destinées à être utilisées dans un appareil d'imagerie à résonance magnétique qui applique des champs magnétiques en gradient et des impulsions d'excitation à radio-fréquences à un objet en cours d'examen placé dans un champ magnétique statique pour induire ainsi une résonance magnétique à l'intérieur d'une région choisie dudit objet, et qui détecte des signaux de résonance magnétique depuis ladite région choisie dudit objet pour obtenir des informations d'imagerie dudit objet, caractérisé en ce qu'il comprend :

- des premiers moyens (11, 12, 13, 14, 15, 31, 32, 33, 34, 35, 39) pour exciter chacune des régions d'une pluralité de régions d'un objet en cours d'examen avec une impulsion d'excitation à radio-fréquences d'une puissance différente ;

- des seconds moyens (16, 36, 37, 39) pour acquérir un signal de résonance magnétique depuis chacune des régions de ladite pluralité de régions excitées par lesdits premiers moyens (11, 12, 13, 14, 15, 31, 32, 33, 34, 35, 39) ;

- des troisièmes moyens (40) pour identifier un signal de résonance magnétique maximum contenu dans lesdits signaux de résonance magnétique acquis par lesdits seconds moyens (16, 36, 37, 34) depuis ladite pluralité de régions dudit objet ; et

- des quatrièmes moyens (40) pour stocker la puissance de l'impulsion d'excitation à radio-fréquences qui a fourni ledit signal de résonance magnétique maximum identifié par lesdits troisièmes moyens (40) comme étant la puissance optimum desdites impulsions d'excitation à radio-fréquences.

5. Système de commande de puissance automatique pour système d'imagerie à résonance magnétique selon la revendication 4, caractérisé en ce que lesdits premiers moyens (11, 12, 13, 14, 15, 31, 32, 33, 34, 35, 39) excitent une pluralité de régions qui sont adjacentes les unes des autres dans l'espace avec des impulsions d'excitation à radio-fréquences de puissances différentes.

6. Système de commande de puissance automatique pour système d'imagerie à résonance magnétique selon la revendication 4 caractérisé en ce qu'il comprend en outre :

- des cinquièmes moyens (11, 12, 13, 14, 15, 31, 32, 33, 34, 35, 39) pour exciter ladite pluralité de régions dudit objet avec des impulsions d'excitation à radio-fréquences d'une puissance égale ;

- des sixièmes moyens (16, 36, 37, 39) pour acquérir des signaux de résonance magnétique depuis ladite pluralité de régions dudit objet excitées par lesdits cinquièmes moyens (11, 12, 13, 14, 15, 31, 32, 33, 34, 35, 39) ; et

- des septièmes moyens (40) pour corriger lesdits signaux de résonance magnétique acquis par lesdits seconds moyens (16, 36, 37, 39) en utilisant lesdits signaux de résonance magnétique acquis par lesdits sixièmes moyens (16, 36, 37, 39) pour chacune des régions de ladite pluralité de régions.

F I G. 1

F I G. 2

EP 0 523 740 B1

F I G. 3

FIG. 4

SLICE #

RF PULSE

Gs

ECHO SIGNAL

RF POWER STRENGTH

MR SIGNAL STRENGTH

P

25mm

2.5mm : 10 SLICES

1  2  3  4  5  10

⇨ APC

⇨ IMAGING

30ms  30ms  30ms  30ms

300ms

```
        ┌─────────────┐
        │    START    │
        └─────────────┘
               │
               ▼
┌──────────────────────────────────────┐
│  EXCITE PLANAR SLICES WITH RF PULSES  │──── 100
│  OF UNEQUAL POWER                     │
└──────────────────────────────────────┘
               │
               ▼
┌──────────────────────────────────────┐
│  ACQUIRE MR SIGNALS FROM SLICES       │──── 102
└──────────────────────────────────────┘
               │
               ▼
┌──────────────────────────────────────┐
│  IDENTIFY MAXIMUM MR SIGNAL           │──── 104
└──────────────────────────────────────┘
               │
               ▼
┌──────────────────────────────────────┐
│  STORE POWER OF RF PULSE CORRESPONDING│
│  TO MAXIMUM MR SIGNAL AS OPTIMUM POWER│
│  OF RF PULSES FOR IMAGING             │──── 106
└──────────────────────────────────────┘
               │
               ▼
        ┌─────────────┐
        │     END     │
        └─────────────┘
```

# F I G. 5

F I G. 6

START

EXCITE PLANAR SLICES WITH
PF PULSES OF UNEQUAL POWER — 200

ACQUIRE MR SIGNALS FROM SLICES — 202

EXCITE PLANAR SLICES WITH
RF PULSES OF EQUAL POWER — 204

ACQUIRE MR SIGNALS FROM
SLICES EXCITED IN STEP 204 — 206

CORRECT MR SIGNALS FROM SLICES
ACQUIRED IN STEP 202 USING MR
SIGNALS FROM SLICES ACQUIRED
IN STEP 204 FOR EACH OF SLICES — 208

IDENTIFY MAXIMUM CORRECTED MR SIGNAL — 210

STORE POWER OF RE PULSE
CORRESPONDING TO MAXIMUM MR
SIGNAL AS OPTIMUM POWER OF RF
PULSES FOR IMAGING — 212

END

F I G. 7